## Europäisches Patentamt

## European Patent Office

## Office européen des brevets

(19)

(11) Veröffentlichungsnummer: **0 267 500 B1**

(12) ## EUROPÄISCHE PATENTSCHRIFT

(45) Veröffentlichungstag der Patentschrift: **25.03.92**

(21) Anmeldenummer: **87115927.3**

(22) Anmeldetag: **29.10.87**

(51) Int. Cl.5: **H02H 3/16**, H02H 3/50, G01R 31/08

(54) **Verfahren und Einrichtung zum Orten eines Erdschlusses eines Leiters in einem Drehstromnetz.**

(30) Priorität: **10.11.86 DE 3638258**

(43) Veröffentlichungstag der Anmeldung:
**18.05.88 Patentblatt 88/20**

(45) Bekanntmachung des Hinweises auf die Patenterteilung:
**25.03.92 Patentblatt 92/13**

(84) Benannte Vertragsstaaten:
**AT CH DE LI SE**

(56) Entgegenhaltungen:
**EP-A- 0 082 103**
**DE-A- 2 735 756**

**ELEKTRIZITÄTSWIRTSCHAFT, Band 76, Nr. 8, 1977, Seiten 202-206; S. KLEEBAUR et al.: "Ortung von Erdschlüssen in Drehstromnetzen mit induktiver Erdung"**

**DRUCKSCHRIFT DER FIRMA SIEMENS: "Der Erdschluss im Netzbetrieb"**

(73) Patentinhaber: **SIEMENS AKTIENGESELL-SCHAFT**
**Wittelsbacherplatz 2**
**W-8000 München 2(DE)**

(72) Erfinder: **Müller, Klaus-Dieter**
**Bucher Strasse 44**
**W-8500 Nürnberg(DE)**

## Beschreibung

Die Erfindung betrifft ein Verfahren und eine Vorrichtung zum Orten eines Erdschlusses eines Leiters in einem Drehstromnetz.

Beim Eintreten von Erdfehlern in isolierten oder gelöschten Freileitungs- oder Kabelnetzen treten Transienten im Bereich zwischen der Netzbetriebsfrequenz, z.B. 50 Hz, und mehreren 1000 Hz auf. Durch Auswertung der Phasenbeziehung zwischen den Strom- und Spannungstransienten läßt sich ein Richtungsentscheid über die relative Lage des Erdschlußortes bezüglich der Meßstelle treffen. Wenn ein Netz genügend dicht mit solchen Meßstellen besetzt ist, ist im Falle eines Erdschlusses eines rasche Einkreisung des Fehlerortes möglich. Der defekte Netzteil kann dann vom Netz abgekoppelt werden, bevor das gesamte Netz abgeschaltet werden muß oder sicherheitstechnische Probleme am Fehlerort auftreten.

Die besagte Transientenauswertung stützt sich auf eine Überwachung des Summenstroms und der Verlagerung der Sternpunktspannung des Drehstromnetzes an der jeweils betrachteten Meßstelle. Hat die im Erdschlußfall auftretende erste Halbwelle der Stromtransiente die gleiche Polarität wie die erste Halbwelle der Spannungstransiente, so liegt der Erdschlußort in Vorwärtsrichtung (bezogen auf die ungestörte Energieflußrichtung); bei entgegengesetzter Polarität der zu vergleichenden Transienten-Halbwellen liegt der Fehlerort in rückwärtiger Richtung. Derartige Erdschlußerkennungsgeräte, wie etwa Erdschlußwischerrelais, sind beispielsweise aus der Siemens-Druckschrift "Der Erdschluß im Netzbetrieb" (Bestell-Nr. E141/1212) bekannt.

Ein grundsätzliches Meßproblem bei Auswertungssystemen der vorliegenden Art besteht in der nie ganz unvermeidlichen Asymmetrie des Drehstromnetzes und seiner Belastung. Deshalb liefern selbst Meßwandler ohne eigene Symmetrietoleranzen auch im stationären, fehlerfreien Betriebszustand von Null verschiedene Summenstrombzw. Verlagerungsspannungssignale, deren notwendige Berücksichtigung eine Verringerung der Empfindlichkeit bedeutet. Die Entscheidungsfähigkeit herkömmlicher Geräte stößt deshalb relativ rasch an ihren Grenzen, wenn die Meßgrößen im Fehlerfall kleiner sind als im stationären Betrieb, z.B. bei sehr hochohmigen Erdschlüssen.

Des weiteren ist ein sicherheitstechnisches Problem mit der Lokalisierung von Dauererdschlüssen verbunden. Diese werden, da mit konventionellen Erdschlußwischerrelais keine Meßwiederholung möglich ist, z.T. in wattmetrischen Meßverfahren geortet, bei denen z.B. eine Wattreststromerhöhung durch Zuschalten eines Widerstandes im Netzsternpunkt gegen Erde notwendig ist, wodurch an der Fehlerstelle die Gefahr von Personen- und Sachschäden erhöht wird.

Aus der Veröffentlichung "Elektrizitätswirtschaft", Band 76, Nr. 8, 1977, Seiten 202-206, "Ortung von Erdschlüssen in Drehstromnetzen mit induktiver Erdung" von S.Kleebaur und E.Wiener sind zwei Relais bekannt. Ein erstes "Erdschlußwischer-Relais" dient zur Erfassung kurzzeitiger Erdschlüsse. Die Fehlerrichtungsermittlung erfolgt dabei durch direkten Phasenvergleich eines Summenstrommeßwertes und eines Verlagerungsspannungsmeßwertes. Ein zweites "ErdschlußortungsRelais" dient zur Erfassung von Dauererdschlüssen. Es beruht auf einer Summenstrommessung. Dabei wird eine rhythmische Änderung der Summenstöme durch pulsartige Verstimmung der Erdschlußspuleneinstellungen bewirkt und ausgewertet.

Die Aufgabe der vorliegenden Erfindung besteht darin, besonders empfindliche und sichere Ortungsverfahren und Ortungseinrichtungen bereitzustellen.

Diese Aufgabe wird erfindungsgemäß gelöst durch die Merkmale der nebengeordneten Ansprüche 1 und 3. Vorteilhafte Ausgestaltungen und Weiterbildungen sind Gegenstand der weiteren Ansprüche.

Der Hauptvorteil der erfindungsgemäßen Lösung liegt in der hohen Empfindlichkeit der Messung des Summenstroms und der Verlagerungsspannung. Dadurch werden Erdschlüsse schneller und sicherer erkannt und aufgefunden, wodurch sehr rasch gezielte Gegenmaßnahmen möglich sind, bevor kostspielige Netzabschaltungen ausgelöst werden. Aufgrund der hohen Meßempfindlichkeit ergibt sich auch noch ein weiterer bedeutsamer Vorteil: Es sind Meßwiederholungen mit hochfrequenten Transienten geringen Energieinhalts möglich, die das Gefährdungspotential an der Stelle von vornherein minimieren.

Die Ausführungsform des Bandsperrfilters durch ein Bandpaßfilter nebst Subtrahierglied ergibt den Vorteil, daß geerdete Induktivitäten eingesetzt werden können, die sich durch mit Kapazitäten beschaltete Gyratorschaltungen in leicht integrierbarer Weise nachbilden lassen.

Anhand eines in der Zeichnung dargestellten Ausführungsbeispiels wird die Erfindung nachstehend näher erläutert. Es zeigt:

Fig. 1     als Blockschaltbild eine Einrichtung zur erfindungsgemäßen Auswertung des Summenstroms und der Verlagerungsspannung eines Drehstromnetzes und zur Lokalisierung eines Erdschlusses in demselben;

Fig. 2     einen Stromlaufplan eines erfindungsgemäß eingesetzten Bandsperrfilters;

Fig. 3     ein Diagramm zum exemplarischen Vergleich der zeitlichen Verläufe eines herkömmlich und eines erfindungsgemäß gewonnenen Verlagerungsspannungssignals.

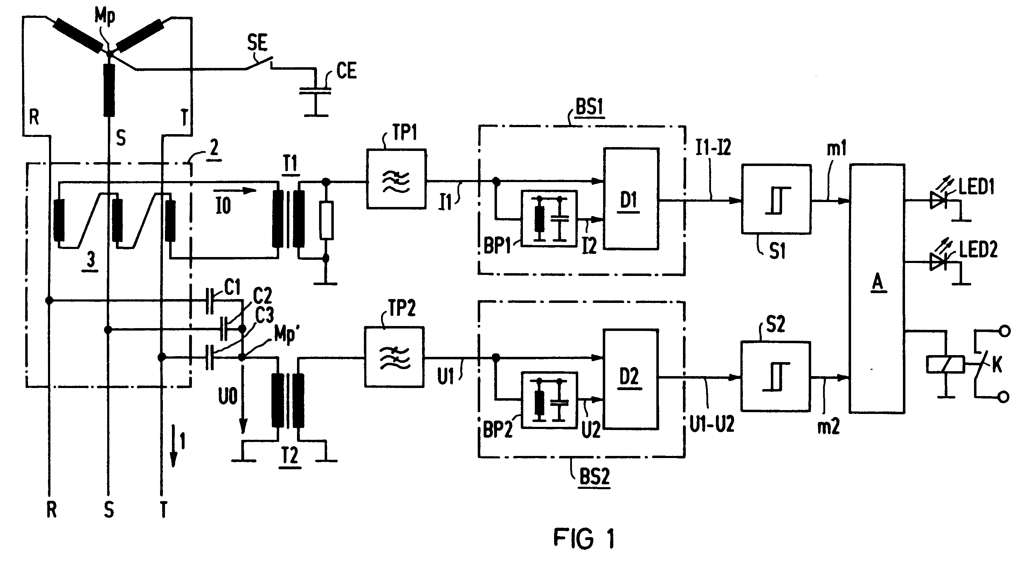

Im Zusammenhang mit dem Blockschaltbild einer erfindungsgemäßen Ortungseinrichtung nach Fig.1 ist auch deren Anbindung an einen Ausschnitt eines Drehstromnetzes RST dargestellt, welches aus sternförmig um den Netzsternpunkt Mp angeordneten Wicklungen gespeist wird. An der Meßstelle 2 wird der dortige Summenstrom I0 des Drehstromnetzes RST mittels einer offenen Dreieckswicklung 3 (oder alternativ gegebenenfalls mittels eines Kabelumbauwandlers) erfaßt und über einen Transformator T1 an die Ortungseinrichtung weitergegeben. Dabei kommt noch eine Tiefpaßfilterung des auszuwertenden Summenstromsignals mittels eines Tiefpasses TP1 mit einer Eckfrequenz zwischen zirka 4 und 10 kHz in Betracht. Das resultierende, den Summenstrom I0 repräsentierende erste Meßsignal I1 wird anschließend einer Bandsperrfilterung unterworfen. Das Bandsperrfilter BS1 ist im Ausführungsbeispiel mittels eines Bandpaßfilters BP1 und eines Subtrahiergliedes D1 realisiert. Die Wirkungsweise des Bandsperrfilters BS1 entspricht jener des weiter unten beschriebenen Bandsperrfilters BS2 für das Verlagerungsspannungssignal.Das am Ausgang des Bandsperrfilters BS1 anstehende gefilterte Meßsignal I1 minus I2 wird der ersten Schwellwertschaltung S1 zugeführt, welche ein Meldesignal m1 abgibt, wenn ihr Eingangssignal I1 minus I2 einen vorgegebenen Schwellenwert überschreitet. Dieses Meldesignal m1 geht an eine Auswerteeinheit A, auf deren Funktion ebenfalls weiter unten noch näher eingegangen wird. Aus der Meßstelle 2 wird neben dem Summenstrom I0 ein die Verlagerungsspannung U0 des Netzsternpunktes Mp repräsentierendes zweites Meßsignal U1 gewonnen, in dem über die Kapazitäten C1,C2,C3 ein Netzsternpunkt Mp' nachgebildet wird. Die so gewonnene Verlagerungsspannung U0 wird über den Transformator T2 und den dem Tiefpaß TP1 entsprechenden Tiefpaß TP2 als Meßsignal U1 an das Bandsperrfilter BS2 weitergegeben. Dieses ist aus dem Bandpaßfilter BP2 und dem Subtrahierglied D2 aufgebaut und arbeitet folgendermaßen: Das Bandpaßfilter BP2 ist auf die Betriebsfrequenz des Drehstromnetzes RST abgestimmt, d.h. z.B. auf 50,60 oder 16 2/3 Hz. Im stationären Zustand läßt das Bandpaßfilter BP2 das auch im stationären Zustand aufgrund Netzasymmetrien unvermeidlich vorhandene Meßsignal U1 ungehindert passieren, so daß die Differenzbildung im nachfolgenden Subtrahierglied D2 zu einer nahezu völligen Signalauslöschung führt (d.h. das gefilterte Signal U1 minus U2 ist näherungsweise 0). Sobald nun aber aufgrund eines Erdschlusses eine Transiente das Meßsignal U1 überlagert, kann das Bandpaßfilter BP2 aufgrund seiner Einschwingträgheit nicht augenblicklich folgen, arbeitet also als gleitender Speicher. Die Subtraktion des gefilterten, trägen Meßsignals U2 vom transientenbehafteten Meßsignal U1 führt so zur Abbildung der reinen Transiente. Die Empfindlichkeit der nachgeschalteten zweiten Schwellwertschaltung S2 kann also - genauso wie jene der ersten Schwellwertschaltung S1 - alleine auf die Transiente ausgerichtet werden und braucht nicht die unvermeidliche stationäre Amplitude des Meßsignals U1 als Unschärfe hinzunehmen, die im Stand der Technik zwangsläufig häufig zu Richtungsfehlentscheidungen führt.

Überschreitungen des vorgegebenen Schwellen werts durch eine Transiente meldet die Schwellwertschaltung S2 als Meldesignal m2 an die Auswerteeinheit A, deren Funktion die Meldung von Erdschlüssen sowie die Abgabe eines Richtungentscheids beinhaltet. Es kann auch vorgesehen sein, daß die Auswerteeinheit A je nach dem Ergebnis ihrer Auswertung bereits selbst Auslösungen veranlaßt, z.B. über einen Relaiskontakt K, der seinerseits eine als erdschlußbehaftet erkannte Stichleitung des Netzes außer Betrieb setzt. Die eigentliche Auswertung der Meldesignale m1, m2 und somit des Summenstroms I0 und der Verlagerungsspannung U0 geschieht in der Weise, daß die Phasenbeziehung zwischen der ersten Halbwelle einer Stromtransiente und der ersten Halbwelle der Spannungstransiente festgestellt wird. Bei Phasengleichheit erfolgt ein sogenannter Vorwärtsentscheid (z.B. angezeigt durch die Leuchtdiode LED1, welcher bedeutet, daß die Fehlerstelle von der Meßstelle ausgesehen in Vorwärtsrichtung liegt, bezogen auf die ungestörte Energieflußrichtung 1. Wird eine entgegengesetzte Phasenbeziehung der genannten ersten Halbwellen festgestellt, so wird ein Rückwärtsentscheid ausgegeben (z.B. angezeigt durch Leuchtdiode LED2), d.h. daß der der Erdschluß von der Meßstelle 2 aus gesehen in rückwärtiger Richtung des Netzes zu finden ist.

In der Regel treten Erdschlüsse eines Leiters eines Drehstromnetzes RST zunächst nur als kurzfristige Ereignisse, sogenannte Wischer, auf, deren Ort und Ursache aber dennoch untersucht werden müssen, um einem Dauererdschluß mit möglicherweise schwerwiegenderen Folgen zuvorzukommen. Es ist nämlich zu bedenken, daß der Erdschluß eines Leiters die Wahrscheinlichkeit eines Erdschlusses eines zweiten Leiters - und damit eines Kurzschlusses - durch Spannungserhöhung der zunächst gesunden Leiter gegenüber Erde vergrößert.

Sobald es zum Erdschluß eines Leiters kommt, steigt die Verlagerungsspannung U0 des nachgebildeten Netzsternpunktes Mp' in die Größenordnung von 100 V. Selbst in diesem Fall ist aber die hier vorgeschlagene Schaltung aufgrund ihres Konzepts der Kompensation stationärer Signalanteile immer noch äußerst empfindlich gegen sich neu ereignende Transienten, z.B. auch künstlich ausgelöste zur näheren Fehlerortung. Dabei ist es aus sicherheitstechnischen Gründen von großer Bedeutung, daß die künstlich ausgelösten Transienten aufgrund der Empfindlichkeit der Ortungseinrichtung energieschwach sein dürfen, wodurch am Fehlerort keine zusätzliche Gefährdung hervorgerufen wird. Als Beispiel für die Auslösung einer künstlichen Transiente wird z.B. eine kleine Erdungskapazität CE mittels eines Erdungsschalters SE den Netzsternpunkt Mp geschaltet.

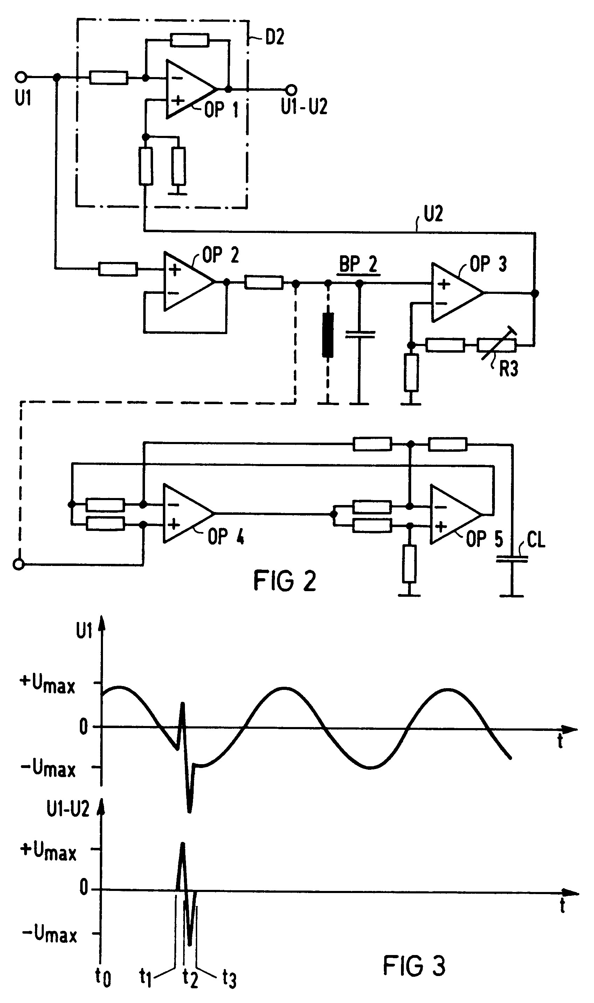

Ein detaillierter Stromlaufplan des Bandsperrfilters BS2 ist in Fig.2 dargestellt. Der frequenzbestimmende Teil des Bandpasses BP2 ist durch die Parallelschaltung aus der Induktivität L und der Kapazität C gegeben, welche als Sperrschwingkreis die Betriebsfrequenz des Drehstromnetzes RST, z.B. 50 Hz, als einzige nicht gegen Masse kurzschließt. Die Induktivität L kann aus Gründen der Miniaturisierung vorteilhafterweise durch eine mit einer Kapazität CL abgeschlossene Gyratorschaltung - siehe Operationsverstärker OP4 und OP5 - simuliert werden. Die Operationsverstärker OP2 und OP3 dienen als Trennverstärker, wobei letzterer über den veränderlichen Widerstand R3 auch noch zum Phasenabgleich für den stationären Zustand dient. Der Operationsverstärker OP1 schließlich bildet die Differenz zwischen dem ungefilterten Meßsignal U1 und dem zugehörigen gefilterten Meßsignal U2.

Anhand des Diagramms der Fig.3 wird abschließend auch graphisch verdeutlicht, wie die mangelnde Empfindlichkeit der Erdschlußerkennungsgeräte des Standes der Technik zu Fehlentscheidungen führen kann und wie letztere durch die hier vorgeschlagene Lösung vermieden werden. Der obere Kurvenzug zeigt ein die Verlagerungsspannung U0 des Netzsternpunktes Mp repräsentierendes Meßsignal U1, welches zwischen den Zeitpunkten t1 und t3 von einer auf einen Erdschluß zurückgehenden Transient enspitze überlagert ist. Wie ersichtlich, ist auch außerhalb des vom Erdschluß betroffenen Zeitintervalls das Meßsignal U1 deutlich von Null verschieden, so daß der Schwellenwert Umax für das Ansprechen der Schwellwertschaltung S2 von vornherein relativ hoch angesetzt werden muß, um nicht auch schon während des fehlerfreien Normalzustandes ständig Meldungen zu veranlassen. Dies hat jedoch zur Folge, daß die erste Halbwelle der Transiente zwischen den Zeitpunkten t1 und t2 nicht zu einem Verlassen des zulässigen Bereiches und damit auch nicht zu einer eigentlich notwendigen Meldung führt. Die erste Halbwelle würde in diesem Fall also fälschlicherweise erst für das Teilintervall zwischen den Zeitpunkten t2 und t3 gemeldet, und zwar mit negativer Polarität. Da es aber andererseits, wie geschildert, ganz wesentlich auf das Erkennen der ersten Halbwelle einer Transiente ankommt, wird die Anfälligkeit der herkömmlichen Entscheidungsfindung gegen Fehler deutlich.

Im Vergleich mit der unteren Kurve des Diagramms nach Fig.3 tritt die Überlegenheit des neu vorgeschlagenen Konzepts plastisch hervor: Der stationäre Anteil des Meßsignals U1 ist unterdrückt, so daß nach Verbleib der reinen Transiente selbst der relativ grobe Schwellenwert Umax genügt, um die Polarität der ersten Halbwelle der Transienten richtig zu detektieren und damit auch zu einem zuverlässigen Richtungsentscheid zu gelangen. Der neugewonnene Spielraum für den Schwellenwert Umax kann vorteilhafterweise für hochempfindliche Erdschlußerfassungeräte genutzt werden.

**Patentansprüche**

1. Verfahren zum Orten eines Erdschlusses eines Leiters in einem Drehstromnetz, wobei
    a) ein erstes Meßsignal (I1) gebildet wird, welches den Summenstrom (I0) im Drehstromnetz (R,S,T) repräsentiert,
    b) die erdschlußbedingten Transienten (I1-I2) im ersten Meßsignal (I1) durch Reduktion um den stationären Anteil (I2) ausgefiltert werden,
    c) ein zweites Meßsignal (U1) gebildet wird, welches die Verlagerungsspannung (U0) im Netzsternpunkt ($M_p, M_p'$) des Drehstromnetzes (R,S,T) repräsentiert,
    d) die erdschlußbedingten Transienten (U1-U2) im zweiten Meßsignal (U1) durch Reduktion um den stationären Anteil (U2) ausgefiltert werden,
    e) die jeweilige Richtung des Erdschlusses durch Auswerten der Phasenbeziehung zwischen den ausgefilteren Transienten (I1-I2,U1-U2) des ersten und zweiten Meßsignales (I1,U1) detektiert wird.

2. Verfahren nach Anspruch 1, **dadurch gekennzeichnet,** daß zur näheren Fehlerortung künstlich ausgelöste Transienten niedrigen Energieinhaltes zusätzlich in das Drehstromnetz (R,S,T) eingespeist werden.

3. Vorrichtung zur Durchführung des Verfahrens nach Anspruch 1, mit
    a) einer ersten Meßanordnung (3,T1) zur Gewinnung eines den Summenstrom (I0) repräsentierenden ersten Meßsignales (I1),
    b) einer ersten Schwellwertschaltung (S1) zur Abgabe eines ersten Meldesignales (ml), wenn das erste Meßsignal (I1) einen

vorgegebenen ersten Schwellenwert überschreitet,

c) einer zweiten Meßanordnung (C1,C2,C3,T2) zur Gewinnung eines die Verlagerungsspannung (U0) des Netzstern-punktes (Mp;Mp') repräsentierenden zwei-ten Meßsignales (U1),

d) einer zweiten Schwellwertschaltung (S2) zur Abgabe eines zweiten Meldesignales (m2), wenn das zweite Meßsignal (U1) einen vorgegebenen zweiten Schwellwert überschreitet,

e) einer Auswerteeinheit (A) zur Auswertung der beiden Meldesignale (m1,m2), wobei ein Richtungsentscheid über die relative Lage des Erdschlußortes bezüglich der Meßstelle (2) getroffen wird, und mit

f) mindestens einem schmalbandigen Bandsperrfilter (BS1;BS2), dessen Sperrfrequenz bei der Betriebsfrequenz des Drehstromnetzes (RST) liegt, zur Filterung mindestens eines der beiden Meßsignale (I1,U1).

4. Vorrichtung nach Anspruch 3, **dadurch gekennzeichnet,** daß das erste bzw. zweite Bandsperrfilter (BS1 bzw. BS2) jeweils enthält

a) ein schmalbandiges Bandpaßfilter (BP1 bzw. BP2) zur Ausfilterung des stationären Anteiles (I2 bzw U2) aus dem ersten bzw. zweiten Meßsignal (I1 bzw. U1), dessen Durchlaßfrequenz auf die Betriebsfrequenz des Drehstromnetzes (R,S,T) abgestimmt ist, und

b) ein Subtrahierglied (D1,D2), dem zur Bildung der erdschlußbedingten Transienten (I1-I2 bzw. U1-U2) das erste bzw. zweite Meßsignal (I1 bzw. U1) und das Ausgangssignal des schmalbandigen Bandpaßfilters (BP1 bzw. BP2) zugeführt werden.

5. Vorrichtung nach Anspruch 3 oder 4, **dadurch gekennzeichnet,** daß im Netzsternpunkt ($M_p$) eine Erdungskapazität (CE) zugeschaltet wird.

6. Vorrichtung nach Anspruch 3, 4 oder 5, **dadurch gekennzeichnet,** daß die mindestens eine Induktivität (L) im ersten bzw. zweiten Bandsperrfilter (BS1 bzw. BS2) durch eine Gyratorschaltung (OP4,OP5,CL) nachgebildet ist.

## Claims

1. Method for locating an earth fault of a conductor in a three-phase system, by which

a) a first measurement signal (I1) is formed, representing the total current (I0) in the three-phase system (R, S, T);

b) the earth fault-conditional transients (I1-I2) in the first measurement signal (I1) are filtered out by means of reduction by the steady-state portion (I2);

c) a second measurement signal (U1) is formed, representing the displacement voltage (U0) in the system neutral point ($M_p$, $M_p'$) of the three-phase system (R, S, T);

d) the earth fault-conditional transients (U1-U2) in the second measurement signal (U1) are filtered out by means of reduction by the steady-state portion (U2);

e) the respective direction of the earth fault is detected by evaluating the phase relationship between the filtered-out transients (I1-I2, U1-U2) of the first and second measurement signal (I1, U1).

2. Method according to claim 1, characterised in that for the purposes of more precise fault location, artificially initiated transients of low energy content are additionally fed into the three-phase system (R, S, T).

3. Arrangement for carrying out the method according to claim 1, having

a) a first measuring arrangement (3, T1) for the purpose of obtaining a first measurement signal (I1) representing the total current (I0);

b) a first threshold circuit arrangement (S1) for the purpose of emitting a first status signal (ml) when the first measurement signal (I1) exceeds a preset first threshold value;

c) a second measuring arrangement (C1, C2, C3, T2) for the purpose of obtaining a second measurement signal (U1) representing the displacement voltage (U0) of the system neutral point (Mp; Mp');

d) a second threshold circuit arrangement (S2) for the purpose of emitting a second status signal (m2) when the second measurement signal (U1) exceeds a preset second threshold value;

e) an evaluation unit (A) for evaluating the two status signals (m1, m2), a direction decision being taken on the relative position of the earth fault location in relation to the measuring point (2); and having

f) at least one narrow-band band-stop filter (BS1; BS2), the stop frequency of which lies at the operating frequency of the three-phase system (RST), for the purpose of filtering at least one of the two measurements signals (I1, U1).

4. Arrangement according to claim 3, characterised in that the first or second band-stop filter (BS1 or BS2), in each case, contains:

a) a narrow-band band-pass filter (BP1 or BP2 respectively) for filtering out the steady-state portion (I2 or U2 respectively) from the first or second measurement signal (I1 or U1 respectively), the pass frequency of which is tuned to the operating frequency of the three-phase system (R, S, T); and

b) a subtracter (D1, D2) to which there are supplied the first or second measurement signal (I1 or U1 respectively) and the output signal of the narrow-band band-pass filter (BP1 or BP2 respectively) for the purpose of forming the earth fault-conditional transients (I1-I2 or U1-U2 respectively).

5. Arrangement according to claim 3 or 4, characterised in that an earthing capacitor (CE) is connected to the system in the system neutral point ($M_p$).

6. Arrangement according to claim 3, 4 or 5, characterised in that the at least one inductor (L) in the first or second band-stop filter (BS1 or BS2 respectively) is simulated by a gyrator circuit arrangement (OP4, OP5, CL).

**Revendications**

1. Procédé pour localiser un défaut à la terre d'un conducteur dans un réseau triphasé, et selon lequel

a) un premier signal de mesure (I1), qui représente le courant (I0) dans le réseau triphasé (R,S,T), est formé,

b) les phénomènes transitoires (I1-I2), conditionnés par le défaut à la terre, dans le premier signal de mesure (I1) sont éliminés par filtrage, en étant réduits de la composante stationnaire (I2),

c) un second signal de mesure (U1), qui représente la tension de décalage (U0) au niveau du neutre ($M_p,M_p'$) du réseau triphasé (R,S,T), est formé,

d) des phénomènes transitoires (U1-U2), conditionnés par le défaut à la terre, dans le second signal de mesure (U1) sont éliminés par filtrage, en étant réduits de la composante stationnaire (U2),

e) la direction respective du défaut à la terre est détectée par évaluation de la relation de phase entre les phénomènes transitoires (I1-I2, U1-U2), éliminés par filtrage, des premier et second signaux de mesure (I1, I2).

2. Procédé selon la revendication 1, caractérisé en ce que, pour une localisation plus précise des défauts, des phénomènes transitoires déclenchés de façon artificielle et présentant un faible contenu en énergie sont introduits en supplément dans le réseau triphasé (R,S,T).

3. Dispositif pour la mise en oeuvre du procéddé suivant la revendication 1, comportant

a) un premier dispositif de mesure (3,T1) servant à former un premier signal de mesure (I1) représentant le courant somme (I0),

b) un premier circuit à valeur de seuil (S1) servant à délivrer un premier signal de signalisation (ml) lorsque le premier signal de mesure (I1) dépasse une première valeur de seuil prédéterminée,

c) un second dispositif de mesure (C1,C2,C3,T2) servant à produire un second signal de mesure (U1) représentant la tension de décalage (U0) du neutre (Mp;Mp') du réseau,

d) un second circuit à valeur de seuil (S2) servant à délivrer un second signal de signalisation (m2) lorsque le second signal de mesure (U1) dépasse une seconde valeur de seuil prédéterminée,

e) une unité d'évaluation (A) servant à évaluer les deux signaux de signalisation (m1,m2), une décision du point de vue du sens étant prise en ce qui concerne la position relative du lieu du défaut à la terre par rapport au point de mesure (2), et

f) au moins un filtre coupe-bande à bande étroite (BS1;BS2), dont la fréquence de blocage est égale à la fréquence de service du réseau triphasé (RST) et qui sert à filtrer au moins l'un des deux signaux de mesure (I1,U1).

4. Dispositif suivant la revendication 3, caractérisé par le fait que le premier ou le second filtre coupe-bande (BS1 ou BS2) contient respectivement

a) un filtre passe-bande à bande étroite (BP1 ou BP2) servant à extraire par filtrage la composante stationnaire (I2 ou U2) du premier ou du second signal de mesure (I1 ou U2) et dont la fréquence passante est réglée sur la fréquence de service du réseau triphasé (R,S,T), et

b) un circuit soustracteur (D1,D2), auquel sont envoyés, pour la formation des phénomènes transitoires (I1-I2 ou U1-U2) conditionnés par le défaut à la terre, le premier ou le second signal de mesure (I1 ou U1) et le signal de sortie du filtre passe-bande à bande étroite (BP1 ou BP2).

5. Dispositif suivant la revendication 3 ou 4, caractérisé par le fait qu'une capacité de mise à la terre (CE) est raccordée en supplément au neutre ($M_p$) du réseau.

6. Dispositif suivant la revendication 3,4 ou 5, caractérisé par le fait que l'inductance (L), prévue au moins en un exemplaire dans le premier ou le second filtre coupebande (BS1 ou BS2) est simulée par un circuit gyrateur (OP4,OP5,CL).

FIG 1

FIG 2

FIG 3